# EUROPÄISCHE PATENTSCHRIFT

(11) **EP 2 936 541 B1**
(45) Veröffentlichungstag und Bekanntmachung des Hinweises auf die Patenterteilung: **01.02.2017**
(21) Anmeldenummer: 13830207.0
(22) Anmeldetag: 18.12.2013
(51) Int. Cl.: H01J 37/32, H05H 1/46, H02M 7/5387, H03F 3/217

(54) **VERFAHREN ZUR ERZEUGUNG EINER HOCHFREQUENZLEISTUNG UND LEISTUNGSVERSORGUNGSSYSTEM MIT EINEM LEISTUNGSWANDLER ZUR VERSORGUNG EINER LAST MIT LEISTUNG**
METHOD FOR PRODUCING HIGH-FREQUENCY POWER AND POWER SUPPLY SYSTEM HAVING A POWER CONVERTER FOR SUPPLYING A LOAD WITH POWER
PROCÉDÉ DE PRODUCTION D'UNE PUISSANCE HAUTE FRÉQUENCE ET SYSTÈME D'ALIMENTATION EN PUISSANCE POURVU D'UN CONVERTISSEUR DE PUISSANCE POUR ALIMENTER UNE CHARGE EN PUISSANCE

(30) Priorität: 18.12.2012 DE 102012223662; 18.12.2012 DE 102012223657
(43) Veröffentlichungstag der Anmeldung: 28.10.2015
(73) Patentinhaber: TRUMPF Hüttinger GmbH + Co. KG, 79111 Freiburg (DE)
(72) Erfinder: GREDE, André, 79110 Freiburg (DE); KRAUSSE, Daniel, 79356 Eichstetten (DE); LABANC, Anton, 79238 Ehrenkirchen (DE); THOME, Christian, 79104 Freiburg (DE); PENA VIDAL, Alberto, 79104 Freiburg (DE)
(74) Vertreter: Nitschke, Moritz
(86) Internationale Anmeldenummer: PCT/DE2013/100429
(87) Internationale Veröffentlichungsnummer: WO 2014/094737

(56) Entgegenhaltungen:
- DE-U1- 9 210 382
- JP-A- S56 141 779

## Beschreibung

Die Erfindung betrifft ein Verfahren zur Erzeugung einer Hochfrequenzleistung, die einer Last zuführbar ist, indem ein Analogsignal durch einen Digital-Analog-Wandler (DAC) erzeugt und in einem Verstärkerpfad verstärkt wird.

Die Erfindung betrifft weiterhin ein Leistungsversorgungssystem mit einem Leistungswandler, der zur Versorgung einer Last mit Leistung mit der Last verbindbar ist, wobei der Leistungswandler einen ersten Verstärkerpfad aufweist.

Die Erfindung betrifft außerdem ein Leistungsversorgungssystem mit einem ein Hochfrequenzsignal erzeugenden Leistungswandler, der zur Versorgung eines Plasma- oder Gaslaserprozesses mit Leistung mit einer Last verbindbar ist, wobei der Leistungswandler zumindest einen ersten Verstärkerpfad aufweist, wobei dem zumindest einen Verstärkerpfad ein von einem Digital-Analog-Wandler (DAC) aus einem Digitalsignal erzeugtes Analogsignal zugeführt ist.

Das Dokument DE 9210382 U1 zeigt ein Leistungsversorgungssystem nach dem Oberbegriff des Anspruchs 1.

Leistungsversorgungssysteme, insbesondere Systeme, die Leistung bei Frequenzen > 1 MHz erzeugen, werden beispielsweise zur Laseranregung, in Plasmabeschichtungsanlagen oder auch für Induktionsanwendungen verwendet. In derartigen Leistungsversorgungssystemen werden häufig mehrere Verstärker verwendet, um daraus eine Gesamtleistung des Leistungsversorgungssystems zu erzeugen. Die von den einzelnen Verstärkern erzeugten Leistungssignale sind häufig nicht phasensynchron. Auch können die Leistungssignale unterschiedliche Amplituden aufweisen. Die Ausgangsleistungen der einzelnen Verstärker, d.h. die Leistungssignale, müssen häufig zu einer Gesamtleistung kombiniert werden, z.B. mittels Kombinierern (Combiner), oder direkt an einer Last, z.B. einer Plasmaelektrode oder einer Gaslaserelektrode. Zum Kombinieren der Ausgangsleistungen sind häufig feste Phasenbeziehungen der Ausgangsleistungen erforderlich. Außerdem sollte die Ausgangsleistung der Verstärker bezüglich ihrer Amplitude zueinander abgestimmt werden.

Weiterhin kann es in einem Leistungsversorgungssystem zu schlagartigen Änderungen der angeforderten Leistung kommen, beispielsweise wenn in der Plasmakammer ein Arc auftritt und entsprechend die gelieferte Leistung schlagartig reduziert werden muss.

Problematisch ist weiterhin, dass es bei derartigen Systemen schwierig ist, die Leistung und insbesondere den Ionisierungsgrad in der Last einzustellen.

Aufgabe der vorliegenden Erfindung ist es daher, ein Leistungsversorgungssystem und ein Verfahren zur Erzeugung einer Leistung, die einem Plasmaprozess oder Gaslaserprozess zuführbar ist, bereit zu stellen, mit denen die Leistung eines Leistungswandlers schnell und zuverlässig eingestellt werden kann. Es ist außerdem Aufgabe der vorliegenden Erfindung, ein Verfahren und ein Leistungsversorgungssystem bereit zu stellen, mit denen die Leistung in der Last, insbesondere ein Ionisierungsgrad des Plasmas, eingestellt werden kann.

Gelöst wird diese Aufgabe erfindungsgemäß durch ein Leistungsversorgungssystem mit einem Hochfrequenz erzeugenden Leistungswandler, der zur Versorgung eines Plasma- oder Gaslaserprozesses mit Leistung mit einer Last verbindbar ist, wobei der Leistungswandler zumindest einen ersten Verstärkerpfad aufweist, wobei dem zumindest einen Verstärkerpfad ein von einem DAC aus einem Digitalsignal erzeugtes Analogsignal zugeführt ist. Dem DAC ist eine Logikschaltungseinheit zur Erzeugung des dem DAC zugeführten Digitalsignals vorgeschaltet, wobei die Logikschaltungseinheit
- einen Signal-Datenspeicher in dem Signal-Datenwerte zur Erzeugung einer Analogsignalform abgelegt sind,
- einen Amplituden-Datenspeicher, in dem Amplituden-Datenwerte zur Beeinflussung der Amplituden der Analogsignale abgelegt sind,
- einen Multiplikator zur Multiplikation der Signal-Datenwerte mit den Amplituden-Datenwerten
   aufweist.

Somit kann auf einfache Art und Weise ein Digitalsignal erzeugt werden, welches Informationen bzgl. der Signalform und der Amplitude des im DAC zu erzeugenden Analogsignals aufweist. Insbesondere kann die Folge von Digitalwerten erzeugt werden, indem mit Hilfe eines Zählers eine Folge von in einem Signaldatenspeicher abgelegten Signaldatenwerten ausgelesen wird, diese Folge von Signaldatenwerten einem Multiplizierer zugeführt wird, und von diesem Multiplizierer mit einem aus einem Amplitudendatenspeicher ausgelesenen Amplitudendatenwert multipliziert wird. Dies hat insbesondere dann Vorteile, wenn parallel mehrere Analogsignale erzeugt werden, die anschließend durch einen Kombinierer kombiniert werden, so dass die zu kombinierenden Signale besonders einfach und schnell aneinander angepasst werden können. Verstärkerpfade, die mit einem so generierten Analogsignal angesteuert sind, sind besonders gut für einen Parallelbetrieb mehrerer Verstärkerpfade geeignet. Die so erzeugten Leistungen können einfach am Ausgang der Verstärkerpfade kombiniert werden. Somit ergibt sich eine sehr schnell und genau abstimmbare Gesamtleistung des Leistungswandlers. Die Last kann dabei ein Plasmaprozess oder ein Gaslaserprozess sein.

Es kann eine digitale Logikschaltung vorgesehen sein, die mit der oder den Logikschaltungseinheit(en) verbunden ist. Durch die Logikschaltungseinheit können die zu multiplizierenden Datenwerte ausgewählt werden.

Die digitale Logikschaltung und ein oder mehrere Logikschaltungseinheiten können in einem Logikbauelement integriert sein. Somit ergibt sich ein hoher Grad der Integration. Es müssen wenige Bauteile eingesetzt werden, was Platz spart und kostengünstig ist.

Mit der Erfindung können die Toleranzen der einzelnen Verstärkerpfade, die durch Bauteile undjoder begrenzte Wiederholgenauigkeit in der Fertigung entstehen, herauskalibriert werden. Dadurch wird das einfache Kombinieren der Leistungen möglich. Damit ergibt sich auch eine Kostenersparnis in der Produktion, da nicht alle Stufen einzeln abgeglichen werden müssen. Der Geschwindigkeitsvorteil entsteht dadurch, dass diese Kalibrationsdaten in einem Speicher abgelegt werden können und durch einen FPGA beim Setzen eines neuen Leistungswertes parallel, also gleichzeitig, auf alle Verstärkerpfade angewendet werden können.

Außerdem lassen sich so mehrere, voneinander unabhängige Leistungswandler oder Leistungserzeugungssysteme untereinander in Phase und/oder Amplitude synchronisieren.

Voraussetzung dafür, dass dieses Konzept funktioniert, ist eine Verstärkertopologie, die sich durch Änderung der Amplitude des einem Verstärkerpfad zugeführten Signals steuern lässt. Um genau zu sein wird der Leistungswandler dazu in verschiedenen Betriebsmodi, insbesondere in verschiedenen Betriebsklassen betrieben. So wird er für kleine Leistungen, z.B. Leistungen kleiner 200 W im linearen Betriebsmodus gehalten, insbesondere in der Betriebsklasse AB. Für hohe Leistungen, insbesondere für Leistungen größer 800W, wird er aber in einem durch Schaltvorgänge bestimmten Betrieb gehalten, insbesondere in einer Betriebsklasse E oder F, besonders bevorzugt in einer Betriebsklasse "F invers" betrieben.

Die Erfindung betrifft weiterhin ein Verfahren zur Erzeugung einer Hochfrequenzleistung, die einer Last zuführbar ist, bei dem zumindest einem Verstärkerpfad ein von einem DAC aus einem Digitalsignal erzeugtes Analogsignal zugeführt und in dem Verstärkerpfad zu einem Hochfrequenzleistungssignal verstärkt wird, wobei das Digitalsignal erzeugt wird, indem ein in einem Signal-Datenspeicher abgelegter Signal-Datenwert mit einem in einem Amplituden-Datenspeicher abgelegten Amplituden-Datenwert multipliziert wird. Ein Analogsignal kann eine Analogspannung sein.

Hierdurch ergeben sich die oben zum Leistungsversorgungssystem beschriebenen Vorteile.

Vorzugsweise wird einem Digitalsignaleingang des DACs eine Folge von Digitalwerten zugeführt, aus denen der DAC das Analogsignal erzeugt. Auf diese Art und Weise kann ein Analogsignal besonders schnell und exakt erzeugt werden.

Die Amplitude der HF-Leistungssignale, also des Ausgangssignals jedes Verstärkerpfads, kann durch eine vorgebbare Amplitude des dem jeweiligen Verstärkerpfad zugeführten Analogsignals beeinflusst werden.

Das Analogsignal kann dem Verstärkerpfad direkt zugeführt werden und eine Veränderung der Amplitude des Analogsignals kann direkt zu einer Veränderung der Amplitude des HF-Leistungssignals des Verstärkerpfads führen. Somit wird insbesondere der Aufwand bezüglich Hardware reduziert. Außerdem wird dadurch sichergestellt, dass keine Amplitudeninformation des Analogsignals verlorengeht, die nachträglich wieder generiert werden muss.

Die Erfindung betrifft weiterhin ein Verfahren zur Kompensation der Toleranzen in Amplitude und Phase der in verschiedenen Verstärkerpfaden erzeugten HF-Leistungssignale, wobei jedem Verstärkerpfad ein von jeweils einem DAC erzeugtes Signal zugeführt wird, das von einer übergeordneten digitalen Speicher-Steuereinheit jeweils in Amplitude und Phase eingestellt wird. Somit ergibt sich eine besonders gute Abstimmung und Kalibrierung.

Die Amplitude jedes HF-Leistungssignals jedes Verstärkerpfads kann durch die Amplitude des vom DAC erzeugten Analogsignals beeinflusst werden.

Erfindungsgemäß kann weiterhin vorgesehen sein, dass bei einer ersten zu erzeugenden Ausgangsleistung dem ersten Verstärkerpfad ein erstes Signal zugeführt wird, bei einer zweiten zu erzeugenden Ausgangsleistung dem ersten Verstärkerpfad ein zweites Signal zugeführt wird, bei der ersten zu erzeugenden Ausgangsleistung dem zweiten Verstärkerpfad ein drittes Signal zugeführt wird, bei der zweiten zu erzeugenden Ausgangsleistung dem zweiten Verstärkerpfad ein viertes Signal zugeführt wird und dass die Amplitude des ersten, zweiten, dritten, und vierten Signals in einem Speicher abgelegt sind.

Gelöst wird die Aufgabe erfindungsgemäß außerdem durch ein Verfahren zur Erzeugung einer Hochfrequenzleistung, die einer Last zuführbar ist, indem ein Analogsignal durch einen DAC erzeugt und in einem Verstärkerpfad verstärkt wird, wobei die Amplitude des Analogsignals moduliert wird. Als Last kommt insbesondere ein Plasmaprozess oder ein Gaslaserprozess in Frage. Durch die Amplitudenmodulation des Analogsignals kann die Leistung, die in die Last geliefert wird, geregelt werden und so beispielsweise der Ionisierungsgrad eines Plasmas in einer Plasmalast besonders einfach eingestellt und gesteuert werden. Plasmalast kann ein Bearbeitungsplasma zum Ätzen oder Beschichten oder auch ein einen Gaslaser anregendes Plasma sein

Die Amplitude des Analogsignals kann moduliert werden, indem einem Digitalsignaleingang des DAC eine Folge von Digitalwerten zugeführt wird, aus denen der DAC das Analogsignal erzeugt. Auf diese Art und Weise kann ein Analogsignal besonders schnell und exakt erzeugt werden.

Die Folge von Digitalwerten kann erzeugt werden, indem ein in einem Sigrialdatenspeicher abgelegter Signaldatenwert mit einem in einem Amplitudendatenspeicher abgelegten Amplitudendatenwert multipliziert wird. Insbesondere kann die Folge von Digitalwerten erzeugt werden, indem mit Hilfe eines Zählers eine Folge von in einem Signaldatenspeicher abgelegten Signaldatenwerten ausgelesen wird, diese Folge von Signaldatenwerten einem Multiplizierer zugeführt wird, und von diesem Multiplizierer mit einem aus einem Amplitudendatenspeicher ausgelesenen Amplitudendatenwert multipliziert wird. Dabei kann ein Analogsignal eine Analogspannung sein. Somit kann auf einfache Art und Weise ein Digitalsignal erzeugt werden, welches Informationen bezüglich der Signalform und der Amplitude des im DAC zu erzeugenden Analogsignals aufweist. Dies hat insbesondere dann Vorteile, wenn parallel mehrere Analogsignale erzeugt werden, die anschließend durch einen Kombinierer kombiniert werden, so dass die zu kombinierenden Signale besonders einfach und schnell aneinander angepasst werden können. Verstärkerpfade, die mit einem so generierten Analogsignal angesteuert sind, sind besonders gut für einen Parallelbetrieb mehrerer Verstärkerpfade geeignet. Die so erzeugten Leistungen können einfach am Ausgang der Verstärkerpfade kombiniert werden. Somit ergibt sich eine sehr schnell und genau abstimmbare Gesamtleistung eines Leistungswandlers.

Die Amplitude des Analogsignals kann moduliert werden, indem der im Amplituden-Datenspeicher abgelegte Amplituden-Datenwert verändert wird. So kann die Amplitudenmodulation besonders schnell erfolgen. Außerdem können mehrere Verstärkerpfade so sehr schnell in ihrer Ausgangsleistung verändert werden und gleichzeitig bleibt die Synchronisierung der Verstärkerpfade untereinander unberührt.

Die Amplitude des Analogsignals kann moduliert werden, indem der im Signal-Datenspeicher abgelegte Signal-Datenwert verändert wird.

Auch so kann die Amplitudenmodulation besonders schnell erfolgen. Außerdem können mehrere Verstärkerpfade so sehr schnell in ihrer Ausgangsleistung verändert werden und eine nichtlineare Verstärkung und Phasenschiebung bei unterschiedlichen Amplituden des Analogsignals der Verstärker kann mit berücksichtigt werden.

Einem Referenzsignaleingang des DAC kann zur Beeinflussung des Analogsignals ein Referenzsignal zugeführt werden. Insbesondere kann dadurch die Amplitude des Analogsignals moduliert werden. Somit kann das Analogsignal nicht nur durch die Folge von Digitalwerten beeinflusst werden, sondern auch durch ein Referenzsignal, welches dem Referenzsignaleingang zugeführt wird. Es stehen somit mehrere Möglichkeiten offen, das Analogsignal zu beeinflussen und exakt einzustellen, insbesondere dessen Amplitude zu modulieren.

Durch die Folge von Digitalwerten kann eine digitale Rampenfunktion realisiert werden. Unter einer digitalen Rampenfunktion versteht man eine durch digitale Werte angegebene Steigung und einen Sollwert. Zum Beispiel kann vorgegeben werden, dass die Leistung mit einer Steigung von 100 W/ms auf 1 kW gesteigert wird.

Weiterhin kann zwischen zwei Amplituden gepulst werden. Dies ist besonders einfach möglich, da dem DAC lediglich Informationen bezüglich Amplitude Phase und Frequenz zugeführt werden müssen. Die Realisierung des Pulsens mit zwei Amplituden ist daher besonders einfach und besonders schnell. Damit kann zum Beispiel in einem Simmerbetrieb die Entladung mit sehr geringer Leistung aufrecht erhalten werden, ohne dass der Material bearbeitende Plasmaprozess fortgeführt wird. Damit ist ein hoher Ionisierungsgrad sehr viel schneller durch Leistungssteigerung möglich als wenn man neu zünden müsste.

Das Analogsignal kann gefiltert werden. Dadurch kann ein besonders oberwellenarmes Signal am Eingang des Verstärkerpfades eingegeben werden. Dies steigert die Effizienz des Gesamtsystems.

Es kann durch mehrere DAC jeweils ein Analogsignal erzeugt werden und in einem jeweils zugeordneten Verstärkerpfad verstärkt werden. Somit können in parallelen Verstärkerpfaden relativ geringe Leistungen erzeugt werden, die anschließend zu einer Gesamtleistung zusammengeführt werden können. Für die einzelnen Verstärkerpfade können wegen der relativ geringen erzeugten Leistungen kostengünstige Bauelemente eingesetzt werden.

Die Ausgangssignale der Verstärkerpfade können mit einem Kombinierer zu einer Gesamtleistung kombiniert werden. Somit kann auf einfache Art und Weise eine hohe Ausgangsleistung des Leistungswandlers realisiert werden.

Die Signaldatenspeicher und Amplitudendatenspeicher können von einem übergeordneten Speicher beschrieben werden. Durch den übergeordneten Speicher kann somit der Inhalt der den DAC zugeordneten Speicher bestimmt und beeinflusst werden.

Die DAC können unter Berücksichtigung der Signallaufzeiten und Verstärkungsfaktoren in den einzelnen Verstärkerpfaden angesteuert werden. Somit kann eine besonders genaue Gesamtleistung eingestellt werden.

Die erzeugte Gesamtleistung und/oder eine von der Last reflektierte Leistung kann erfasst und einer übergeordneten Steuerung zugeführt werden. Somit ist eine besonders genaue Regelung und Steuerung der Gesamtleistung möglich.

In den Rahmen der Erfindung fällt außerdem ein Leistungsversorgungssystem mit einem Leistungswandler, der zur Versorgung einer Last mit Leistung mit der Last verbindbar ist, wobei der Leistungswandler einen ersten Verstärkerpfad aufweist, dem ein von einem DAC erzeugtes amplitudenmoduliertes Analogsignal zugeführt ist. Insbesondere ist eine besonders schnelle und flexible Amplitudenmodulation möglich, die an Plasma- und Laseranwendungen genutzt werden kann. Mit dem erfindungsgemäßen Leistungsversorgungssystem ist die Amplitudenmodulation eines Leistungswandlers mit beliebiger Einhüllender zur Steuerung beispielsweise des Ionisierungsgrads des Plasmas möglich.

Dem DAC kann eine Logikschaltungseinheit zur Erzeugung eines dem DAC zugeführten Digitalsignals vorgeschaltet sein, wobei die Logikschältungseinheit einen Signaldatenspeicher, in dem Signaldatenwerte zur Erzeugung einer Analogsignalform abgelegt sind, einem Amplitudendatenspeicher, in dem Amplitudendatenwerte zur Beeinflussung der Amplituden der Analogsignale abgelegt sind, und einen Multiplikator zur Multiplikation der Signaldatenwerte mit den Amplitudendatenwerten aufweist.

Somit kann auf einfache Art und Weise ein Digitalsignal erzeugt werden, welches Informationen bezüglich der Signalform und der Amplitude des im DAC zu erzeugenden Analogsignals aufweist. Es ergeben sich die bezüglich des Verfahrens erwähnten Vorteile.

Die Signaldatenwerte können insbesondere eine Phaseninformation und/oder eine Frequenzinformation für das zu erzeugende Analogsignal aufweisen.

Es können zumindest zwei Verstärkerpfade vorgesehen sein, wobei jedem Verstärkerpfad ein jeweils von einem DAC aus einem Digitalsignal erzeugtes Analogsignal zugeführt ist und jedem DAC eine Logikschaltungseinheit vorgeschaltet ist. Durch diese Maßnahme ergibt sich eine besonders kompakte Bauweise für hohe Ausgangsleistungen. Damit lassen sich Fertigungsaufwand und Kosten sparen. Außerdem wird ein solcher Aufbau zuverlässiger. Ein solcher Leistungswandler ist besonders gut kalibrierbar und abstimmbar.

Es kann eine digitale Logikschaltung vorgesehen sein, die mit der oder den Logikschaltungseinheit(en) verbunden ist. Durch die Logikschaltungseinheit können die zu multiplizierenden Datenwerte ausgewählt werden.

Die digitale Logikschaltung und ein oder mehrere Logikschaltungseinheiten können in einem Logikbauelement integriert sein. Somit ergibt sich ein hoher Grad der Integration. Es müssen wenige Bauteile eingesetzt werden, was Platz spart und kostengünstig ist.

Das amplitudenmodulierte Analogsignal kann eine Spannung, ein Strom oder eine Leistung sein. Mit dem Begriff "Amplitude" eines Signals ist hier die maximale Auslenkung einer periodisch verlaufenden Wechselgröße gemeint.

Die Signaldatenwerte und/oder die Amplitudendatenwerte können in Nachschautabellen (Look-Up-Table, LUT) abgelegt sein und dort besonders einfach für eine einzustellende Signalform und Amplitude bzw. Amplitudenmodulation ausgewählt werden.

Der Signal- und der Amplituden-Datenspeicher können als Nachschautabellen (Look-Up-Table, LUT) ausgebildet sein. Dadurch lässt sich Speicherplatz einsparen, da in den eigentlichen Datenbeständen (mit einer hohen Anzahl von Einträgen) nur ein Kurzcode geführt und die zugehörige Langbezeichnung aus der Tabelle verwendet werden kann. In der Nachschautabelle können für bestimmte Konstellationen vorberechnete Ergebnisse oder andere Informationen definiert werden. Auf die Berechnung von Werten kann somit verzichtet werden, so dass die Analogsignale und damit die Leistung extrem schnell angepasst werden können.

Der DAC kann einen Referenzsignaleingang aufweisen. Dieser Referenzsignaleingang kann verwendet werden, um die Generierung des Analogsignals zu beeinflussen. Eine Veränderung des Analogsignals kann auf diese Weise besonders schnell herbeigeführt werden.

Dem Referenzsignaleingang kann eine Ansteuerschaltung vorgeschaltet sein. Mit Hilfe einer solchen Ansteuerschaltung kann das Eingangssignal des Referenzsignaleingangs schnell verändert werden, um dadurch auch schnell eine Veränderung des erzeugten Analogsignals, insbesondere dessen Amplitudenmodulation, zu bewirken.

Eine besonders kompakte Bauweise ergibt sich, wenn der DAC und die zugeordneten Logikschaltungseinheiten in einem Direkt-Digital-Synthese (DDS-Baustein) integriert sind.

Wenn zwischen dem DAC und dem Verstärkerpfad eine Filteranordnung zur Filterung des Analogsignals vorgesehen ist, kann ein besonders oberwellenarmes Signal am Eingang des Verstärkerpfades eingegeben werden. Das vermindert störende Oberwellen im Verstärkerpfad. Diese steigert die Effizienz des Gesamtsystems.

Der Leistungswandler kann mehr als zwei Verstärkerpfade aufweisen, denen jeweils ein DAC zugeordnet ist, der dem jeweiligen Verstärkerpfad ein Analogsignal zuführt. Durch diese Maßnahme ergibt sich eine besonders kompakte Bauweise für hohe Ausgangsleistungen. Ein solcher Leistungswandler ist besonders gut abstimmbar.

Die Verstärkerpfade können mit einem Kombinierer zur Kombination der in den Verstärkerpfaden erzeugten Leistungen zu einer Gesamtleistung verbunden sind. Hierbei können relativ einfache Kombinierer verwendet werden, die günstiger in der Herstellung sind, aber hohe Anforderungen hinsichtlich der Phasenlage, Amplituden und Frequenzen der Eingangssignale stellen. Der Leistungswandler kann hierdurch in besonders kompakter Bauweise und kostengünstig aufgebaut werden.

Der Kombinierer zur Kombination der in den Verstärkerpfaden erzeugten Leistungen kann ohne Ausgleichsimpedanzen für Eingangssignale ungleicher Stärke und/oder Phasenlage ausgelegt sein. Ein solcher Kombinierer ist besonders energiesparend und kostengünstig. Außerdem kann ein solcher Kombinierer sehr kompakt und mit wenigen Bauteilen aufgebaut werden.

Die Verstärkerpfade können Transistoren in LDMOS-Technologie aufweisen. LDMOS steht für "laterally diffused metal oxide semiconductor". Das sind MOSFETs, die bisher vor allem im GHz-Bereich Anwendung fanden. Die Verwendung dieser Transistoren im Bereich unter 200 MHz ist bislang noch nicht bekannt. Beim Einsatz in Verstärkern zur Erzeugung einer Leistung, die einem Plasmaprozess oder einem Laser zuführbar ist, hat sich überraschenderweise gezeigt, dass sich diese Transistoren in LDMOS-Technologie sehr viel zuverlässiger verhalten als vergleichbare herkömmliche MOSFETs. Dies kann auf eine sehr viel höhere Strombelastbarkeit zurückzuführen sein. Insbesondere bei Versuchen mit mehreren Verstärkerpfaden und bei Frequenzen von 3,4 MHz, 13 MHz, 27 MHz, 40 MHz und 162 MHz haben diese Transistortypen eine besonders hohe Zuverlässigkeit gezeigt. Ein weiterer Vorteil dieser Transistortypen gegenüber herkömmlichen MOSFETs besteht darin, dass die identischen Transistoren für die genannten Frequenzen (3,4 MHz, 13 MHz, 27 MHz, 40 MHz und 162 MHz) einsetzbar sind. Damit lassen sich nun mit einer sehr ähnlichen oder auch mit einer gleichen Topologie Verstärker- und Leistungsversorgungssysteme aufbauen, die bei Frequenzen über mehrere Dekaden im Bereich von 1 MHz bis 200 MHz einsetzbar sind. Das sind Frequenzen, wie sie in Plasmaprozessen und zur Gaslaseranregung oft benutzt werden. Die Frequenz ist durch einfache Veränderung der Ansteuerung der DAC einstellbar, die Amplitude durch Veränderung der Werte im Digitalspeicher bzw. in den Nachschautabellen oder über den Referenzsignaleingang des DACs. Herkömmliche MOSFETs haben bei diesen Frequenzen betrieben an Plasmaprozessen oftmals Probleme, wenn zu viel in den Plasmaprozess gelieferte Leistung reflektiert wird. Deswegen musste die erzeugte Leistung oft begrenzt werden, um die reflektierte Leistung nicht über eine kritische Grenze ansteigen zu lassen. Damit ließen sich die Plasmaprozesse nicht immer sicher zünden oder im gewünschten Leistungsbereich betreiben. Außerdem wurden aufwändige regelbare Impedanzanpassungsschaltungen vorgesehen, um diese Nachteile zu beheben. LDMOS-Transistoren sind nun besonders vorteilhaft einsetzbar, wenn mit reflektierter Leistung in erheblichem Maß zu rechnen ist, wie dies beispielsweise bei der Versorgung von Plasmaprozessen der Fall ist. In Verbindung mit dem oben erwähnten Kombinierer besteht der Vorteil der LDMOS-Transistoren darin, dass sehr viel höhere reflektierte Leistungen von den Transistoren aufgenommen werden können. Dadurch werden die Anforderungen an zusätzliche zwischen Leistungsversorgungssystem und Last geschaltete Impedanzanpassungsnetzwerke niedriger und es können bei diesen Impedanzanpassungsnetzwerken Kosten für Bauteile und Regelung eingespart werden.

Jedem Verstärkerpfad kann ein eigener DAC mit zugeordneter Logikschaltungseinheit zugeordnet sein, wobei ein übergeordneter Speicher, insbesondere eine Look-Up-Tabelle, vorgesehen ist, der mit den dem DAC zugeordneten Logikschaltungseinheiten verbunden ist. Durch den übergeordneten Speicher können die den DAC zugeordneten Speicher beschrieben werden. Es ergibt sich ein Gesamtsystem, welches für sehr hohe Leistungen geeignet ist und welches in kompakter Bauweise realisiert werden kann. Auch ist das System hinsichtlich der Ausgangsleistung sehr gut einstellbar und abstimmbar.

Der übergeordnete Speicher kann in der Logikschaltung integriert sein. Weiterhin kann die Ansteuerschaltung für den Referenzsignaleingang zumindest eines DAC in dem Logikbauelement, das als programmierbarer Logikbaustein (PLD), insbesondere Field Programmable Gate Array (FPGA) ausgebildet sein kann, integriert sein. Die Logikschaltung kann durch einen digitalen Signalprozessor angesteuert sein.

Insbesondere können zusätzlich die DAC in diesem PLD bzw. FPGA integriert sein. Weiterhin kann die Ansteuerschaltung für den Referenzsignaleingang zumindest eines DAC in einem PLD bzw. FPGA integriert sein. Das PLD bzw. FPGA kann durch einen digitalen Prozessor, insbesondere durch einen digitalen Signalprozessor (DSP) angesteuert sein. Diese Maßnahmen tragen dazu bei, dass eine kompakte Bauweise für hohe Leistungen realisiert werden kann und dass der Leistungswandler sehr gut abstimmbar ist.

Es kann eine Messeinrichtung, insbesondere ein Richtkoppler, vorgesehen sein, die mit einer Systemsteuerung verbunden ist, die wiederum die Logikschaltung zumindest mittelbar, insbesondere über einen digitalen Prozessor oder DSP, ansteuert. Dadurch kann eine sehr genaue und sehr schnelle Regelung der einem Plasmaprozess zugeführten Leistung realisiert werden.

Die erzeugte Gesamtleistung und/oder eine von einer Last, insbesondere Plasmakammer, reflektierte Leistung kann erfasst und einer übergeordneten Steuerung zugeführt werden. Auf diese Art und Weise kann die Ausgangsleistung des Leistungswandlers gesteuert oder geregelt werden. Das kann auch direkt im FPGA auf einer Leiterkarte bestehend aus FPGA und DDS und eventuell DSP erfolgen.

Weitere Merkmale und Vorteile der Erfindung ergeben sich aus der nachfolgenden Beschreibung eines Ausführungsbeispiels der Erfindung, anhand der Figuren der Zeichnung, die erfindungswesentliche Einzelheiten zeigen und aus den Ansprüchen. Die einzelnen Merkmale können je einzeln für sich oder zu mehreren in beliebiger Kombination bei einer Variante der Erfindung verwirklicht sein.

Ein bevorzugtes Ausführungsbeispiel der Erfindung ist in der Zeichnung schematisch dargestellt und wird nachfolgend mit Bezug zu den Figuren der Zeichnung näher erläutert. Es zeigen:
- Fig.1: in stark schematisierter Darstellung ein Plasmasystem mit einem Leistungsversorgungssystem;
- Fig. 2: in einer Blockdarstellung ein Leistungsversorgungssystem;
- Fig. 3: in einer Blockdarstellung einen DDS-Baustein.

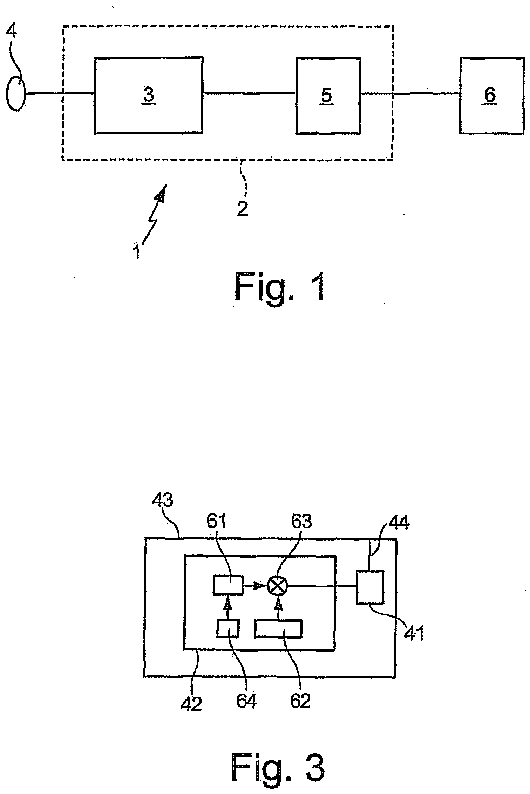

Die Figur 1 zeigt ein Plasmasystem 1, welches ein Leistungsversorgungssystem 2 umfasst. Das Leistungsversorgungssystem 2 weist wiederum einen Leistungswandler 3 auf, der an ein Spannungsversorgungsnetz 4 angeschlossen sein kann. Die am Ausgang des Leistungswandlers 3 erzeugte Leistung wird über ein Impedanzanpassungsnetzwerk 5 an eine Plasmakammer 6 als Last gegeben, wo ein Plasma erzeugt wird, mithilfe dessen eine Plasmabearbeitung in der Plasmakammer 6 durchgeführt werden kann. Insbesondere kann ein Werkstück geätzt werden oder kann eine Materialschicht auf ein Substrat aufgebracht werden.

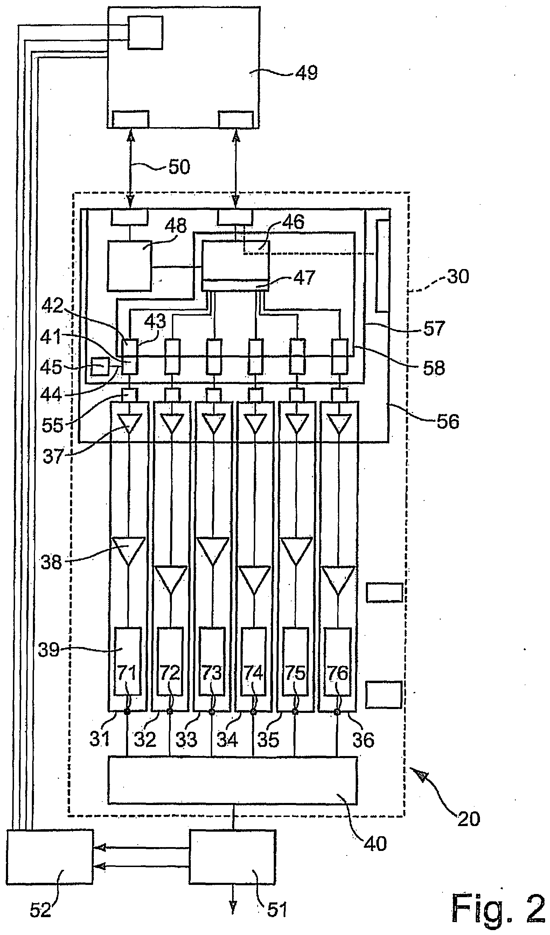

Die Figur 2 zeigt in stark schematisierter Darstellung ein Leistungsversorgungssystem 20. Das Leistungsversorgungssystem 20 weist einen Leistungswandler 30 auf, der eine Ausgangsleistung erzeugt, die einer Last, beispielsweise einem Plasmaprozess oder einer Laseranregung, zugeführt werden kann. In dem Leistungswandler 30 sind mehrere Verstärkerpfade 31 - 36 vorgesehen. Die Verstärkerpfade 31 - 36 sind weitestgehend identisch aufgebaut. Daher wird nachfolgend nur noch der Verstärkerpfad 31 beschrieben. Die Verstärkerpfade 31 - 36 weisen mehrere Verstärker 37, 38 auf, die geeignet sind, ein Analogsignal zu verstärken. Am Ende der Verstärkerpfade 31 - 36 ist jeweils ein Verstärker 39 mit zumindest einem LDMOS-Transistor vorgesehen, dessen Ausgang direkt oder indirekt, z.B. über ein Impedanzanpassungsglied und/oder Filter, auf einen Kombinierer 40 geschaltet ist. Insbesondere sind sämtliche Ausgänge sämtlicher Verstärkerpfade 31 - 36, insbesondere in gleicher Weise, auf den Kombinierer 40 geschaltet. Durch den Kombinierer 40 werden die Einzelleistungen der Verstärkerpfade 31 - 36 zu einer Gesamtleistung gekoppelt.

Dass die Verstärkerpfade 31 - 36 weitestgehend identisch aufgebaut sind, bedeutet nicht zwingend, dass sie die gleiche Verstärkung besitzen. Bauteilstreuung und Toleranzen beim Aufbau der Schaltungen können zu erheblichen Differenzen in der Phase und/oder in der Amplitude der in den Verstärkerpfaden 31 - 36 erzeugten Hochfrequenzleistungssignalen bei identischem Eingangssignal führen.

Den Verstärkerpfaden 31 - 36 ist jeweils ein DAC 41 vorgeschaltet, dem eine Logikschaltungseinheit 42 zugeordnet ist. Insbesondere werden dem DAC 41 aus der Logikschaltungseinheit 42 Folgen von Digitalwerten zugeführt, aus denen der DAC 41 ein analoges Ausgangssignal erzeugt, welches einem Verstärkerpfad 31 - gegebenenfalls nach Filterung durch einen optionalen Filter 55 - zugeführt wird. Der DAC 41 und die Logikschaltungseinheit 42 können in einem sogenannten Direkt-Digital-Synthese-Baustein (DDS-Baustein) 43 integriert sein, auch genannt: Direct-Digital-Synthesizer. Jedem der Verstärkerpfade 31 - 36 ist ein eigener DDS-Baustein 43 und entsprechend ein DAC 41 und eine Logikschaltungseinheit 42 zugeordnet. Beispielhaft ist der DDS-Baustein 43 in Figur 3 beschrieben.

Die Logikschaltungseinheit 42 weist hier auf:
1. einen Signal-Datenspeicher 61, in dem Signal-Datenwerte zur Erzeugung der Analogsignalform abgelegt sind,
2. einen Amplituden-Datenspeicher 62, in dem Amplituden-Datenwerte zur Beeinflussung der Amplituden der Analogsignale abgelegt sind,
3. einen Multiplikator 63 zur Multiplikation der Signal-Datenwerte mit den Amplituden-Datenwerten und
4. einen Zähler 64, der dafür sorgt, dass in einem vorbestimmten Takt Signal-Datenwerte aus dem Signal-Datenspeicher 61 ausgelesen und dem Multiplikator zugeführt werden.

Sowohl der Signal-Datenspeicher 61 als auch der Amplituden-Datenspeicher 62 können als sogenannte Nachschautabellen (Look-Up-Tables, LUT) ausgebildet sein.

Der DAC 41 weist weiterhin einen Referenzsignaleingang 44 auf, dem eine Ansteuerschaltung 45 vorgeschaltet sein kann, um ein Referenzsignal zu erzeugen. Die Ansteuerschaltung 45 kann in der noch zu beschreibenden digitalen Logikschaltung (Programmable Logic Device, PLD) 46 realisiert werden. Die digitale Logikschaltung kann als eine Feld programmierbare (Logik-)Gatter-Anordnung Field Programmable Gate Array (FPGA) ausgebildet sein.

Durch das am Referenzsignaleingang 44 eingegebene Referenzsignal kann das Ausgangssignal, also das generierte Analogsignal des DAC 41, beeinflusst, insbesondere amplitudenmoduliert, werden. Dem DDS-Baustein 43 ist die digitale Logikschaltung 46 vorgeschaltet, welche ebenfalls einen als Look-Up-Table (LUT) ausgebildeten Speicher 47 aufweist. In dem Speicher 47 können Amplituden-Datenwerte abgelegt sein, die vom Speicher 47 in den Amplituden-Datenspeicher 62 geschrieben werden können. Auch über die Wahl der Amplituden-Datenwerte kann eine Amplitudenmodulation bewirkt. Zusätzlich können auch Daten zur Phasenkorrektur abgelegt sein. Die Werte, die im Speicher 47 abgelegt sind, dienen der Kompensierung von Unterschieden in den Verstärkerpfaden (31-36) oder in nachgeschalteten Kombinierern 40. Sie können der Logikschaltungseinheit 42, insbesondere dem Amplituden-Datenspeicher 62 übergeben werden. Die digitale Logikschaltung 46 wird durch einen digitalen Prozessor, insbesondere Digitalen Signalprozessor (DSP) 48, angesteuert, der mit einer Systemsteuerung 49 über einen Datenbus 50 in Verbindung steht.

Der digitale Prozessor, insbesondere Digitale Signalprozessor (DSP) 48, der Speicher 47 und die Logikschaltungseinheiten 42 können in einem Logikbauelement 58 realisiert werden. Das Logikbauelement kann als digitale Logikschaltung PLD, insbesondere FPGA 58 ausgebildet sein. Wenn auch noch die DAC 41 integriert werden, ergibt sich ein kompakter Logikbaustein 57. Der digitale Prozessor insbesondere DSP 48, der Speicher 47, die DDS-Bausteine 43 und auch die DAC 41 sowie die Filter 55 und die ersten Verstärker 37 können auf einer Leiterkarte 56 realisiert werden. Die identische Leiterkarte 56 kann für eine Vielzahl unterschiedlicher Leistungsversorgungssysteme mit unterschiedlichen Leistungen, unterschiedlichen Frequenzen und unterschiedlichen Lasten (Laser, Plasma etc.) eingesetzt werden.

Die Ausgangsleistung des Kombinierers 40 wird über eine als Richtkoppler 51 ausgebildete Messeinrichtung an eine Last, z.B. einen Plasmaprozess, gegeben. Durch den Richtkoppler 51 kann die ausgegebene Leistung und eine von der Last reflektierte Leistung erfasst werden. Die Messsignalaufbereitung erfolgt mit Messmitteln 52, die mit dem Richtkoppler 51 in Verbindung stehen. Die Messmittel 52 sind wiederum mit der Systemsteuerung 49 verbunden. Somit kann über die Systemsteuerung 49 anhand der erfassten Ausgangsleistung und der erfassten reflektierten Leistung bestimmt werden, welche Ausgangsleistung vom Kombinierer 40 erzeugt werden soll. Entsprechend dieser Vorgabe kann die Systemsteuerung 49 den DSP 48 und dieser wiederum die digitale Logikschaltung 46 ansteuern.

In den Messmitteln kann eine Arcerkennung realisiert sein. Um eine schnelle Reaktion auf einen Arc zu erreichen, kann die Arcerkennung, d.h. die Messmittel, unmittelbar mit dem DAC 41, insbesondere dessen Referenzsignaleingang 44, oder der Ansteuerschaltung 45, in Verbindung stehen.

In dem Speicher 47 sind Digitalwerte abgespeichert, die sowohl eine Amplitudeninformation als auch eine Phasen- und ggf. auch eine Frequenzinformation enthalten, so dass am Ausgang des DAC 41 ein Analogsignal mit einer vorgegebenen Amplitude, Frequenz- und Phasenlage erzeugt werden kann. Dadurch ist es möglich, die Ausgangssignale der einzelnen Verstärkerpfade 31 - 36 aufeinander abzustimmen, so dass diese im Kombinierer 40 insbesondere für eine verbesserte Ausgangsleistung gekoppelt werden können. Insbesondere können auf diese Art und Weise sehr einfache Kombinierer 40 ohne Verlust erzeugende Ausgleichsimpedanzen eingesetzt werden und eine Verlustleistung gering gehalten werden.

Durch die erfindungsgemäße Art und Weise, ein analoges Signal zu erzeugen, kann sehr schnell die Leistung im Ausgang des Kombinierers 40 beeinflusst und verändert werden.

## Patentansprüche

1. Leistungsversorgungssystem (2, 20) mit einem ein Hochfrequenzsignal erzeugenden Leistungswandler (3, 30), der zur Versorgung eines Plasma- oder Gaslaserprozesses mit Leistung mit einer Last (6) verbindbar ist, wobei der Leistungswandler (3, 30) zumindest einen ersten Verstärkerpfad (31) aufweist, wobei dem zumindest einen Verstärkerpfad (31-36) ein von einem Digital-Analog-Wandler (DAC) (41) aus einem Digitalsignal erzeugtes Analogsignal zugeführt ist, **dadurch gekennzeichnet, dass** dem DAC (41) eine Logikschaltungseinheit (42) zur Erzeugung des dem DAC zugeführten Digitalsignals vorgeschaltet ist, wobei die Logikschaltungseinheit (42)
a. einen Signal-Datenspeicher (61), in dem Signal-Datenwerte zur Erzeugung einer Analogsignalform abgelegt sind,
b. einen Amplituden-Datenspeicher (62), in dem Amplituden-Datenwerte zur Beeinflussung der Amplituden der Analogsignale abgelegt sind,
c. einen Multiplikator (63) zur Multiplikation der Signal-Datenwerte mit den Amplituden-Datenwerten
aufweist.

2. Leistungsversorgungssystem nach Anspruch 1, wobei zumindest zwei Verstärkerpfade (32-36) vorgesehen sind, wobei jedem Verstärkerpfad ein jeweils von einem DAC (41) aus einem Digitalsignal erzeugtes Analogsignal zugeführt ist und jedem DAC (41) eine Logikschaltungseinheit (42) vorgeschaltet ist.

3. Leistungsversorgungssystem nach einem der vorhergehenden Ansprüche, wobei eine digitale Logikschaltung (46) vorgesehen ist, die mit der oder den Logikschaltungseinheit(en) (42) verbunden ist.

4. Leistungsversorgungssystem nach einem der vorhergehenden Ansprüche, wobei der DAC (41) und die zugeordneten Logikschaltungseinheiten (42) jeweils in einem Direkt-Digital-Synthese- (DDS)-Baustein (43) integriert sind.

5. Leistungsversorgungssystem nach einem der vorhergehenden Ansprüche, wobei der Leistungswandler (30) mehr als zwei Verstärkerpfade (31-36) aufweist, denen jeweils ein DAC (41) zugeordnet ist, der dem jeweiligen Verstärkerpfad (31-36) ein Analogsignal zuführt.

6. Leistungsversorgungssystem nach einem der vorhergehenden Ansprüche, wobei die Verstärkerpfade (31-36) mit einem Kombinierer (40) zur Kombination der in den Verstärkerpfaden (31-36) erzeugten Leistungen zu einer Gesamtleistung verbunden sind.

7. Leistungsversorgungssystem nach einem der vorhergehenden Ansprüche , wobei der Kombinierer (40) zur Kombination der in den Verstärkerpfaden (31-36) erzeugten Leistungen ohne Ausgleichsimpedanzen für Eingangssignale ungleicher Stärke und/oder Phasenlage ausgelegt ist.

8. Leistungsversorgungssystem nach einem der vorhergehenden Ansprüche, wobei die Verstärkerpfade (31-36) Transistoren (39) in LDMOS-Technologie aufweisen.

9. Leistungsversorgungssystem nach einem der vorhergehenden Ansprüche, wobei jedem Verstärkerpfad (31-36) ein eigener DAC (41) mit zugeordnetem Logikschaltelement (42) zugeordnet ist, wobei ein übergeordneter Speicher (47), insbesondere eine Look-Up-Table vorgesehen ist, der mit den den DACs (41) zugeordneten Logikschaltelementen (42) verbunden ist.

10. Leistungsversorgungssystem nach einem der vorhergehenden Ansprüche, wobei dem ersten Verstärkerpfad (31 - 36) ein von einem DAC (41) erzeugtes amplitudenmoduliertes Analogsignal zugeführt ist.

11. Leistungsversorgungssystem nach einem der vorhergehenden Ansprüche, wobei der DAC (41) einen Referenzsignaleingang (44) aufweist und dem Referenzsignaleingang (44) eine Ansteuerschaltung (45) vorgeschaltet ist.

12. Verfahren zur Erzeugung einer Hochfrequenzleistung, die einer Last (6) zuführbar ist, bei dem zumindest einem Verstärkerpfad (31-36) ein von einem DAC (41) aus einem Digitalsignal erzeugtes Analogsignal zugeführt und in dem Verstärkerpfad zu einem Hochfrequenzleistungssignal verstärkt wird, wobei das Digitalsignal erzeugt wird, indem ein in einem Signal-Datenspeicher (61) abgelegter Signal-Datenwert mit einem in einem Amplituden-Datenspeicher (62) abgelegten Amplituden-Datenwert multipliziert wird.

13. Verfahren zur Erzeugung einer Hochfrequenzleistung nach Anspruch 12, wobei die Amplitude des Analogsignals moduliert wird.

14. Verfahren nach Anspruch 13, wobei die Amplitude des Analogsignals moduliert wird, indem einem Digitalsignaleingang des DAC (41) eine Folge von Digitalwerten zugeführt wird, aus denen der DAC (41) das Analogsignal erzeugt.

15. Verfahren nach Anspruch 14, wobei die Folge von Digitalwerten erzeugt wird, indem ein in einem Signal-Datenspeicher (61) abgelegter Signal-Datenwert mit einem in einem Amplituden-Datenspeicher (62) abgelegten Amplituden-Datenwert multipliziert wird.

## Claims

1. A power-supply system (2, 20) comprising a power converter (3, 30) which generates a high-frequency signal and which can be connected to a load (6) in order to supply a plasma or gas-laser process with power, wherein the power converter (3, 30) comprises at least a first amplifier path (31), wherein an analogue signal generated by a digital-to-analogue converter (DAC) (41) from a digital signal is supplied to the at least one amplifier path (31-36), **characterised in that**
a logic-circuit unit (42) for generating the digital signal supplied to the DAC is provided upstream of the DAC (41), wherein the logic-circuit unit (42) comprises:
a. a signal-data buffer (61), in which signal-data values for generating an analogue signal shape are stored,
b. an amplitude-data buffer (62) in which amplitude-data values for influencing the amplitudes of the analogue signals are stored,
c. a multiplier (63) for multiplying the signal-data values by the amplitude-data values.

2. The power-supply system according to claim 1, wherein at least two amplifier paths (32-36) are provided, wherein an analogue signal generated by a respective DAC (41) from a digital signal is supplied to each amplifier path, and a logic-circuit unit (42) is connected upstream to each DAC (41).

3. The power-supply system according to any one of the preceding claims,
wherein a digital logic-circuit (46) is provided which is connected to the one or more logic-circuit unit(s) (42).

4. The power-supply system according to any one of the preceding claims, wherein the DAC (41) and the associated logic-circuit units (42) are each integrated in a direct-digital synthesis (DDS) module (43).

5. The power-supply system according to any one of the preceding claims, wherein the power converter (30) provides more than two amplifier paths (31-36) to each of which a DAC (41), which supplies an analogue signal to the respective amplifier path (31-36), is allocated.

6. The power-supply system according to any one of the preceding claims, wherein the amplifier paths (31-36) are connected to a combiner (40) in order to combine the powers generated in the amplifier paths (31- 36) to form a total power.

7. The power-supply system according to any one of the preceding claims, wherein the combiner (40) is designed to combine the powers generated in the amplifier paths (31-36) without compensating impedances for input signals of unequal strength and / or phase position.

8. The power-supply system according to any one of the preceding claims, wherein the amplifier paths (31-36) comprise transistors (39) in LDMOS technology.

9. The power-supply system according to any one of the preceding claims, wherein a dedicated DAC (41) with associated logic-circuit element (42) is associated with each amplifier path (31-36), wherein a higher-level buffer (47), in particular a look-up table, is provided, which is connected to the logic-circuit elements (42) associated with the DACs (41).

10. The power-supply system according to any one of the preceding claims, wherein an amplitude-modulated analogue signal generated by a DAC (41) is supplied to the first amplifier path (31-36).

11. The power-supply system according to any one of the preceding claims, wherein the DAC (41) comprises a reference-signal input (44), and a drive circuit (45) is connected upstream of the reference-signal input (44).

12. A method for generating high-frequency power, which can be supplied to a load (6), wherein an analogue signal generated by a DAC (41) from a digital signal is supplied to the at least one amplifier path (31-36) and is amplified in the amplifier path to form a high-frequency power signal, wherein the digital signal is generated by multiplying a signal-data value stored in a signal-data buffer (61) by an amplitude-data value stored in an amplitude-data buffer (62).

13. The method for generating a high-frequency power according to claim 12, wherein the amplitude of the analogue signal is modulated.

14. The method according to claim 13, wherein the amplitude of the analogue signal is modulated by supplying a sequence of digital values, from which the DAC (41) generates the analogue signal, to a digital signal input of the DAC (41).

15. The method according to claim 14, wherein the sequence of digital values is generated by multiplying a signal-data value stored in a signal-data buffer (61) by an amplitude-data value stored in an amplitude-data buffer (62).

## Revendications

1. Système d'alimentation en puissance (2, 20) avec un convertisseur de puissance (3, 30) générant un signal à haute fréquence, qui pour alimenter en puissance un processus au plasma ou au laser à gaz peut être connecté sur une charge (6), le convertisseur de puissance (3, 30) comportant au moins un premier chemin d'amplification (31), à l'au moins un chemin d'amplification (31 à 36) étant amené un signal analogique créé à partir d'un signal numérique par un convertisseur numérique-analogique (DAC) (41), **caractérisé en ce qu'**en amont du DAC (41) est montée une unité de circuit logique (42) destinée à générer le signal numérique amené vers le DAC, l'unité de circuit logique (42) comportant
a. une mémoire de données de signaux (61) dans laquelle sont sauvegardées des valeurs de données de signaux, pour créer une forme de signal analogique,
b. une mémoire de données d'amplitudes (62) dans laquelle sont sauvegardées des valeurs de données d'amplitude, pour influencer les amplitudes des signaux analogiques,
c. un multiplicateur (63) pour la multiplication des valeurs de données de signaux par les valeurs de données d'amplitude.

2. Système d'alimentation en puissance selon la revendication 1, au moins deux chemins d'amplification (32 à 36) étant prévus, à chaque chemin d'amplification étant amené un signal analogique créé chaque fois par un DAC (41) à partir d'un signal numérique et en amont de chaque DAC (41) étant montée une unité de circuit logique (42).

3. Système d'alimentation en puissance selon l'une quelconque des revendications précédentes, un circuit logique numérique (46) étant prévu, qui est connecté avec l'unité ou les unités de circuit logique (42).

4. Système d'alimentation en puissance selon l'une quelconque des revendications précédentes, le DAC (41) et les unités de circuits logiques (42) associées étant intégrés respectivement dans un module (43) de synthèse numérique directe (DDS).

5. Système d'alimentation en puissance selon l'une quelconque des revendications précédentes, le convertisseur de puissance (30) comportant plus de deux chemins d'amplification (31 à 36), auxquels est respectivement associé un DAC (41) qui amène vers le chemin d'amplification (31 à 36) respectif un signal analogique.

6. Système d'alimentation en puissance selon l'une quelconque des revendications précédentes, les chemins d'amplification (31 à 36) étant connectés avec un combineur (40) pour la combinaison des puissances générées dans les chemins d'amplification (31 à 36) en une puissance globale.

7. Système d'alimentation en puissance selon l'une quelconque des revendications précédentes, le combineur (40) étant conçu pour combiner les puissances générées dans les chemins d'amplification (31 à 36) sans impédances d'équilibrage pour des signaux d'entrée d'intensité et/ou de position de phase inégale.

8. Système d'alimentation en puissance selon l'une quelconque des revendications précédentes, les chemins d'amplification (31 à 36) comportant des transistors (39) en technologie LDMOS.

9. Système d'alimentation en puissance selon l'une quelconque des revendications précédentes, à chaque chemin d'amplification (31 à 36) étant associé un propre DAC (41) avec élément de circuit logique (42) associé, une mémoire (47) directrice, notamment une Look-Up-Table étant prévue qui est connectée avec les éléments de circuit logique (42) associés aux DAC (41).

10. Système d'alimentation en puissance selon l'une quelconque des revendications précédentes, au premier chemin d'amplification (31 à 36) étant amené un signal analogique à amplitude modulée généré par une DAC (41).

11. Système d'alimentation en puissance selon l'une quelconque des revendications précédentes, le DAC (41) comportant une entrée de signal de référence (44) et en amont de l'entrée de signal de référence (44) étant monté un circuit d'activation (45).

12. Procédé destiné à générer une puissance haute fréquence qui peut être amenée vers une charge (6), lors duquel un signal analogique créé par un DAC (41) à partir d'un signal numérique est amené vers au moins un chemin d'amplification (31 à 36) et dans le chemin d'amplification est amplifié en un signal de puissance haute fréquence, le signal numérique étant créé en ce qu'une valeur de données de signal sauvegardée dans une mémoire de données de signaux (61) est multipliée par une valeur de données d'amplitude sauvegardée dans une mémoire de données d'amplitude (62).

13. Procédé destiné à générer une puissance haute fréquence selon la revendication 12, lors duquel l'amplitude du signal analogique est modulée.

14. Procédé selon la revendication 13, l'amplitude du signal analogique étant modulée en ce qu'à une entrée de signaux numériques du DAC (41) est amenée une séquence de valeurs numériques à partir desquelles le DAC (41) créé le signal analogique.

15. Procédé selon la revendication 14, la séquence de valeurs numérique étant créée en multipliant une valeur de données de signaux sauvegardée dans une mémoire de données de signaux (61) par une valeur de données d'amplitude sauvegardée dans une mémoire de données d'amplitude (62).
